(19) Europäisches Patentamt
European Patent Office
Office européen des brevets

(11) **EP 1 940 023 A2**

(12) **DEMANDE DE BREVET EUROPEEN**

(43) Date de publication:
**02.07.2008 Bulletin 2008/27**

(51) Int Cl.:
***H03H 17/02*** *(2006.01)*

(21) Numéro de dépôt: **07123139.3**

(22) Date de dépôt: **13.12.2007**

(84) Etats contractants désignés:
**AT BE BG CH CY CZ DE DK EE ES FI FR GB GR HU IE IS IT LI LT LU LV MC MT NL PL PT RO SE SI SK TR**
Etats d'extension désignés:
**AL BA HR MK RS**

(30) Priorité: **22.12.2006 FR 0611266**

(71) Demandeur: **THALES**
**92200 Neuilly sur Seine (FR)**

(72) Inventeur: **HALLE, Michel**
**78340, LES CLAYES SOUS BOIS (FR)**

(74) Mandataire: **Lucas, Laurent Jacques**
**Marks & Clerk France**
**Conseils en Propriété Industrielle**
**31-33 Avenue Aristide Briand**
**94117 Arcueil Cedex (FR)**

(54) **Banque de filtres numériques cascadable et circuit de réception comportant une telle banque de filtre en cascade**

(57) La présente invention concerne une banque de filtres numériques pouvant être connecté en cascade. Elle concerne également un circuit de réception comportant une telle banque de filtres en cascade.

Le signal numérique étant échantillonné à une fréquence d'échantillonnage donnée Fs, la banque de filtres numériques cascadable comporte au moins :
- en entrée, un circuit (31) de transposition en fréquences du signal numérique ;
- un filtre polyphase (30), recevant en entrée le signal numérique transposé en fréquences cadencé à la fréquence d'échantillonnage Fs et comportant un filtre à FFT (32) ayant un nombre N de points ;

la sortie dudit dispositif de filtrage conservant un nombre donné de sorties (36) du filtre à FFT (32) de façon à ce que le débit d'informations binaires en sortie dudit dispositif soit égal au débit d'informations binaires en entrée.

L'invention s'applique notamment pour des récepteurs de signaux radars de type hétérodyne.

FIG.3

EP 1 940 023 A2

**Description**

La présente invention concerne un dispositif de filtrage d'un signal numérique échantillonné formant une banque de filtres numériques pouvant être connectée en cascade. Elle concerne également un circuit de réception comportant une telle banque de filtres en cascade. L'invention s'applique notamment pour les récepteurs de signaux radars de type hétérodyne.

La qualité de la chaîne de réception d'un radar est un élément clé pour assurer une bonne détection ou interprétation des signaux reçus. Pour améliorer la réception une transposition de fréquence est généralement effectuée à l'entrée de la chaîne de réception. La fréquence de réception est transposée dans une fréquence dite intermédiaire pour améliorer l'isolation de la chaîne de réception. De telles chaînes de réception sont dites hétérodynes ou encore superhétérodynes.

Les récepteurs modernes superhétérodynes utilisés pour la réception des signaux radars peuvent notamment se décomposer en quatre parties :

- une chaîne analogique effectuant une transposition des signaux hyperfréquences en fréquence intermédiaire FI, la sortie étant constituée d'un ou plusieurs canaux dont la bande passante instantanée est de l'ordre de 500 MHz par exemple ;
- une conversion analogique-numérique codant le signal FI par un convertisseur 8 à 10 bits par exemple à une cadence instantanée pouvant être supérieure à $10^9$ échantillons par seconde ;
- un traitement numérique, exécuté dans un circuit programmable de type FPGA (acronyme de l'expression anglo-saxonne Field Programmable Gate Array), ayant pour rôle de filtrer, de détecter et de caractériser les signaux, ce traitement permettant de mesurer pour chaque impulsion radar les paramètres globaux tels que le niveau de puissance, la fréquence, la durée, l'instant d'arrivée et éventuellement des informations complémentaires intra-impulsionnelles telles que les modulations de fréquence, de phase ou d'amplitude ;
- une chaîne matérielle et/ou logicielle assurant notamment les traitements de plus haut niveau tels que le désentrelacement, le pistage, l'identification ou la localisation.

La troisième partie concernant notamment les fonctions de filtrage et de détection présente une spécificité qui réside notamment dans la très grande variété des signaux à traiter. Le spectre en fréquences d'une impulsion radar peut occuper de quelques centaines de Kilohertz (kHz) à plusieurs centaines de mégahertz (MHz). Un récepteur optimal au sens de la probabilité de détection est un récepteur qui présente une bande passante adaptée au spectre fréquentiel de chaque signal, correspondant en fait à l'optimisation du rapport signal à bruit pour chaque signal. Pour réaliser un tel récepteur optimal, il est donc nécessaire que ce dernier dispose simultanément de plusieurs banques de filtres.

Une solution connue utilise deux chaînes de filtrage.

Dans une première chaîne, le filtrage est effectué par une transformée de Fourier rapide (FFT) programmable, comportant par exemple de 64 à 2048 points, sans recouvrement avec une loi de pondération telle que chaque sortie de la FFT se comporte comme un filtre dont la bande passante à 50 dB est d'environ 4 fois la fréquence de calcul de la FFT. Cette fonction de filtrage présente au moins deux inconvénients :

- une seule FFT est présente à la fois, la détection ne se fait donc pas de façon optimale sur tous les types de signaux ;
- les sorties ne respectent pas le critère de Nyquist, il faudrait en effet 4 FFT pour respecter ce critère, elles ne permettent donc pas la caractérisation précise des signaux détectés.

Une deuxième chaîne est donc nécessaire pour effectuer notamment des caractérisations fines. Il est alors nécessaire d'ajouter à la chaîne précédente une seconde voie de un ou plusieurs convertisseurs digitaux DDC, selon l'expression anglo-saxonne « Digital Down Converter ». Le rôle de ces filtres DDC est de filtrer efficacement les signaux afin d'effectuer des mesures précises dans les domaines fréquentiels et temporels. Ces filtres DDC sont pilotés par la voie spectrale. Ici encore se pose le problème du choix de la largeur optimale de ces filtres DDC. Le nombre de filtres DDC est égal au nombre de signaux pouvant être acquis simultanément, ce qui peut conduire à des réalisations lourdes et complexes.

Un but de l'invention est de pallier les inconvénients précités en permettant notamment la détection et la caractérisation optimale de signaux radars simultanés et de tous types. A cet effet, l'invention a pour objet un dispositif de filtrage d'un signal numérique échantillonné à une fréquence d'échantillonnage donnée Fs, comportant au moins :

- en entrée, un circuit de transposition en fréquences du signal numérique ;
- un filtre polyphase, cadencé à la fréquence d'échantillonnage Fs du signal numérique entrant, recevant en entrée le signal numérique transposé en fréquences et comportant un filtre à FFT ayant un nombre N de points ; la sortie dudit dispositif de filtrage conservant un nombre donné de sorties du filtre à FFT de façon à ce que le débit d'informations binaires en sortie dudit dispositif soit égal au débit d'informations binaires en entrée.

N/2 sorties du filtre à FFT sont par exemple conservées.

Le circuit de transposition en fréquences effectue par exemple une transposition sensiblement égale à Fs/2N.

Le circuit de transposition en fréquences peut être avantageusement un multiplieur complexe multipliant le signal numérique en entrée par le nombre complexe :

$$\exp(2j\pi\frac{Fs}{2N}t)$$

exp () représentant la fonction exponentielle et t représentant le temps.

L'invention a également pour objet un circuit de réception d'un signal comportant un circuit de conversion analogique-numérique du signal reçu et un circuit de filtrage du signal reçu numérisé, formé de dispositifs de filtrage tels que celui défini précédemment, connectés en cascade, chaque dispositif de filtrage formant un étage de la cascade, les sorties d'un dispositif de filtrage étant connectées à l'entrée du dispositif de filtrage suivant, l'ensemble des filtres de sortie des différents étages formant une banque de filtres, au moins un filtre étant adapté au signal reçu numérisé.

Le circuit de réception comporte par exemple un circuit de détection formé de circuits de détections élémentaires, un circuit de détection élémentaire étant connecté en sortie des filtres de chaque étage.

Les sorties des circuits de détection élémentaires sont, par exemple, reliées à un circuit de synthèse pour traiter les signaux filtrés.

Avantageusement, chaque circuit de détection élémentaire peut être relié à un étage via un circuit à retard compensant le temps de transition du signal dans les étages précédents.

Le circuit de réception comporte, par exemple, en amont du circuit de conversion analogique-numérique un circuit de transposition en fréquences du signal reçu.

Avantageusement, le circuit de réception est incorporé dans la chaîne de réception de signaux radar.

D'autres caractéristiques et avantages de l'invention apparaîtront à l'aide de la description qui suit faite en regard de dessins annexés qui représentent :

- la figure 1, une illustration des fonctions d'une chaîne de réception superhétérodyne de signaux radars ;
- la figure 2, une réalisation selon l'art antérieur des fonctions de filtrage à l'intérieur de cette chaîne de réception ;
- la figure 3, un exemple de réalisation d'un filtre numérique cascadable selon l'invention ;
- la figure 4, la partie filtrage d'une chaîne de réception comportant des filtres selon la figure 3 connectés en cascade ;
- les figures 5a à 5d, des illustrations d'un ensemble formant une banque de filtres.

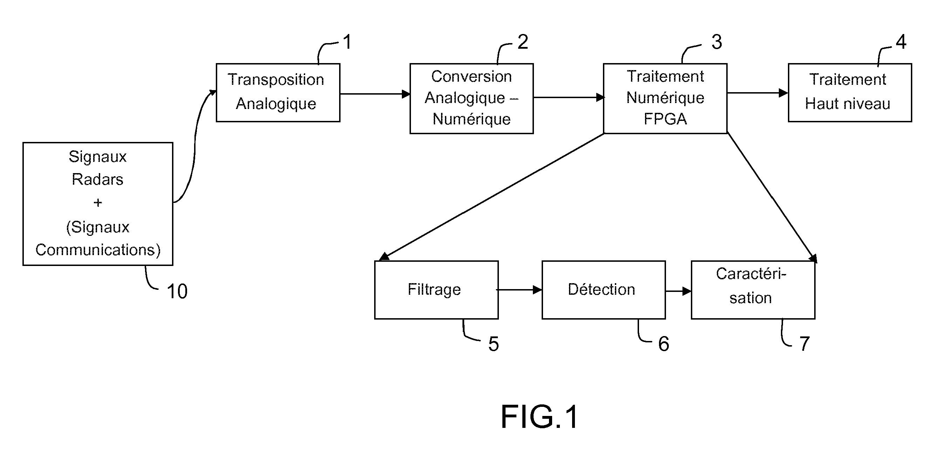

La figure 1 illustre les fonctions d'une chaîne de traitement en réception, mettant notamment en oeuvre les quatre parties décrites précédemment. Des signaux radars 10, ou par exemple des signaux de communication, sont reçus par une chaîne de transposition analogique 1. Dans cette chaîne, la fréquence des signaux est transposée en fréquence intermédiaire FI. Puis une conversion analogique-numérique 2 est effectuée. Le traitement numérique décrit précédemment est effectué sur les signaux numérisés. Comme indiqué précédemment, cette troisième partie comporte une fonction de filtrage 5 suivie d'une fonction de détection 6 et de caractérisation 7. Enfin la troisième partie 3 peut être suivie d'une quatrième partie 4 assurant des fonctions de plus haut niveau.

Une spécificité de la troisième partie 3 réside dans la très grande variété de signaux à traiter qui peut imposer de disposer simultanément de plusieurs banques de filtres, par exemple :

2 filtres de 320 MHz
4 filtres de 160 MHz
8 filtres de 80 MHz
16 filtres de 40 MHz
32 filtres de 20 MHz
64 filtres de 10 MHz
128 filtres de 5 MHz
256 filtres de 2.5 MHz
512 filtres de 1.25 MHz
1024 filtres de 0.625 MHz

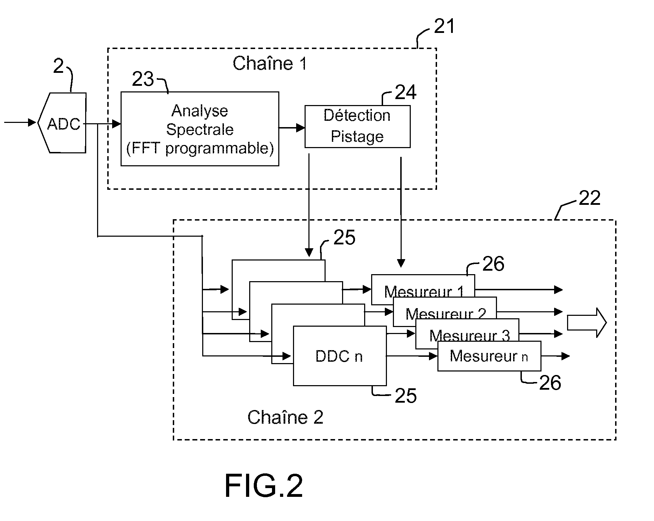

La figure 2 illustre une solution selon l'art antérieur telle que mentionnée précédemment. Le signal numérisé en sortie du convertisseur 2 est pris en compte par deux chaînes de filtrage 21, 22. La première chaîne 21 comporte en entrée un module d'analyse spectrale 23 où un filtrage est effectué par FFT programmable. Le module de filtrage est suivi d'un module de détection et de pistage 24 par exemple, assurant la fonction de la quatrième partie 4. Dans certains cas, la première chaîne 21 peut être suffisante, mais si des caractérisations fines doivent notamment être effectuées, il est alors nécessaire d'ajouter la deuxième chaîne 22 comportant un ou plusieurs filtres DDC 25. Ces filtres sont suivis de mesureurs 26 effectuant des mesures fines sur les signaux isolés par les DDC par exemple. Le problème de la largeur optimale des filtres DDC se pose, ainsi que leur nombre.

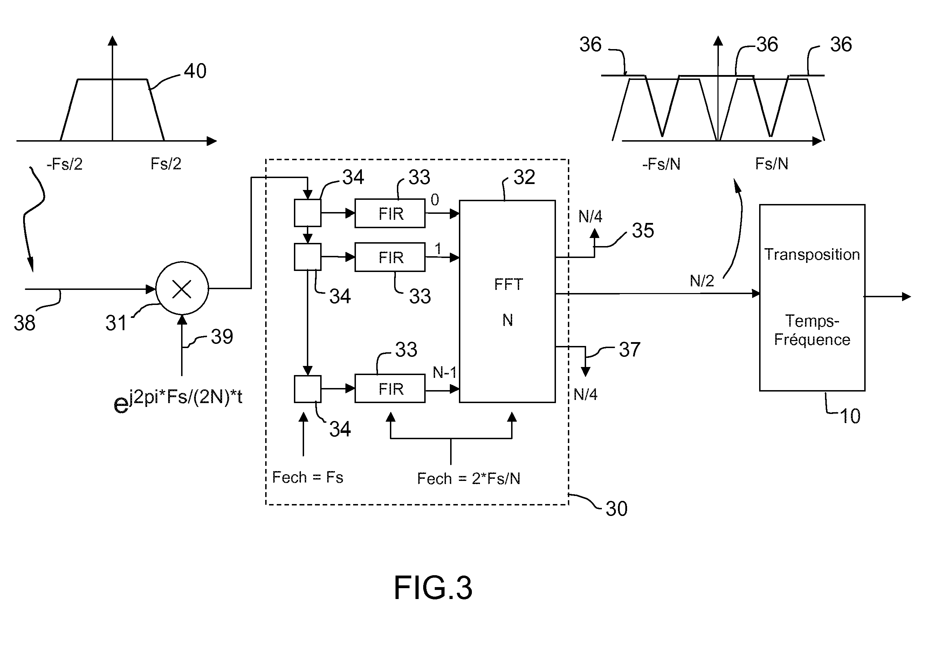

La figure 3 illustre le principe de réalisation d'un dispositif selon l'invention. En particulier, elle montre un exemple de réalisation d'un filtre polyphase selon l'invention.

L'invention repose notamment sur une mise en cascade de fonctions de filtres polyphases. Cette fonction subdivise un canal d'entrée ayant une largeur de bande de fréquence B en N canaux ayant une largeur de fréquences B/N en sortie.

Le filtre de la figure 3 comporte un filtre polyphase de type connu 30 équipé en entrée d'un circuit de transposition de fréquence 31 et ne conservant en sortie que la moitié des sorties du filtre 30.

Le filtre polyphase 30 comporte un circuit de filtrage à transformée de Fourier rapide FFT 32. Un filtre à FFT est généralement précédé d'une fonction de pondération de longueur égale au nombre de points de la FFT où chacun des coefficients est appliqué à chaque entrée de la FFT. Un filtre polyphase améliore un filtre à FFT avec fonction de pondération classique en augmentant la longueur de la fonction de pondération, cette dernière étant par exemple une approximation d'une fonction du type sin(x)/x. Le principe de réalisation d'un filtre polyphase revient ainsi à utiliser une FFT de N points précédée d'une fonction de pondération de longueur K fois supérieure au nombre de points de la FFT, K étant un nombre entier. Dans l'exemple de la figure 3 la FFT comporte N points. Les coefficients de pondération sont, par exemple, réalisés par N filtres 33 à réponse impulsionnelle finie, notés encore FIR, chacun de ces filtres ayant une longueur K, c'est-à-dire étant composé de K coefficients. Un premier filtre 33 est affecté au premier point 0 de la FFT, un deuxième filtre est affecté au deuxième point 1 de la FFT et ainsi de suite jusqu'à un dernier filtre qui est affecté au dernier point N -1 de la FFT. Les sorties 35, 36, 37 de la FFT forment une banque de N filtres voisins dont la réponse fréquentielle est la transformée de Fourier de la loi de pondération. La largeur de chaque filtre est Fs/N, Fs étant la fréquence d'échantillonnage du signal d'entrée.

Ce principe de filtre polyphase permet de réaliser des filtres de très bonne qualité, proche d'un filtre idéal d'allure rectangulaire. A titre d'exemple, pour un facteur K égal à 8, le filtre polyphase 30 permet d'obtenir :

- un recouvrement de 20% ;
- une ondulation dans la bande passante d'un filtre inférieure à 0,1 dB ;
- une réjection en dehors de cette bande supérieure à 50 dB ;
- une largeur à 50 dB inférieure à 2xFs/N.

Pour respecter le critère de Nyquist un filtre polyphase double le débit par rapport au débit d'entrée. La fréquence de calcul du filtre est en effet telle que le débit de sortie est égal à au moins deux fois le débit d'entrée.

Ainsi, si le rythme de calcul du filtre polyphase est égal à 2xFs/N les sorties de la FFT respectent le critère de Nyquist. Avec ce rythme de calcul le débit d'informations en sortie est doublé par rapport au débit en entrée, ce qui donne N filtres échantillonnés à 2xFs/N. Il n'est alors pas possible de mettre un tel filtre en cascade.

Selon l'invention, seul la moitié du filtre est par exemple conservée en sortie du filtre polyphase 30. De cette façon, le débit numérique en sortie reste égal au débit numérique en entrée. En effet, pour rendre le filtre cascadable, c'est-à-dire pour pouvoir le monter en cascade, il ne faut pas doubler le débit en sortie de chaque filtre cascadé sous peine de devoir utiliser une quantité de matériel trop importante, et pratiquement rédhibitoire.

Afin de rendre le filtre polyphase cascadable, le débit en sortie est donc, par exemple, conservé égal au débit en entrée. A cet effet, l'invention ne conserve par exemple en sortie du filtre polyphase 30 que la moitié des filtres. Cependant, cela entraîne une réduction de la bande utile. Les expériences réalisées par la Demanderesse ont montré que ce problème pouvait être résolu en transposant le signal en amont d'une demi-largeur de filtre, soit Fs/2N dans l'exemple de la figure 3. Cette transposition permet par ailleurs de conserver un filtre symétrique en sortie.

La transposition 31 est, par exemple, réalisée par un multiplieur complexe. Ce circuit 31 comporte sur une première entrée 38 le signal d'entrée, échantillonné à la fréquence Fs, puis sur une deuxième entrée 39 le signal complexe suivant :

$$C = \exp(2j\pi \frac{Fs}{2N} t)$$

exp( ) représentant la fonction exponentielle et t représentant le temps.

Le signal de sortie du multiplieur complexe 31 est envoyé vers le filtre polyphase 30. Plus particulièrement, ce signal est envoyé par exemple vers des registres à décalage 34 connectés en série. A chaque coup d'horloge, à la fréquence d'échantillonnage Fs, le signal numérisé d'entrée est transféré d'un registre à l'autre avant d'être filtré par un filtre FIR 33 fonctionnant au double de la fréquence d'échantillonnage divisé par le nombre N de points de la FFT, soit à la fréquence 2Fs/N.

Le filtre de la figure 3 permet donc d'obtenir en sortie N/2 canaux de filtrage 36 de largeur 2xFs/N espacés de Fs/N à partir d'un canal d'entrée 40, de largeur Fs, laissant passer les signaux d'entrée 38. Seul les filtres centraux 36 sont par exemple conservés, N/4 filtres 35, 37 étant rejetés de chaque côté. Les filtres 35, 37 rejetés restent par exemple inutilisés.

Pour permettre une mise en cascade les sorties du filtre, formées des N/2 sorties de la FFT, sont par exemple reliées à l'entrée d'un circuit de transposition temps-fréquence 10. Ce circuit permet en pratique de relier les sorties parallèles de la FFT à une entrée série d'un filtre suivant connecté en cascade. Plus particulièrement, le circuit de transposition temps-fréquence est par exemple une mémoire numérique qui, à la fréquence de calcul de la FFT:

- reçoit en entrée un échantillon temporel de N/2 filtres ;
- fournit en sortie N/2 échantillons temporels d'un même filtre.

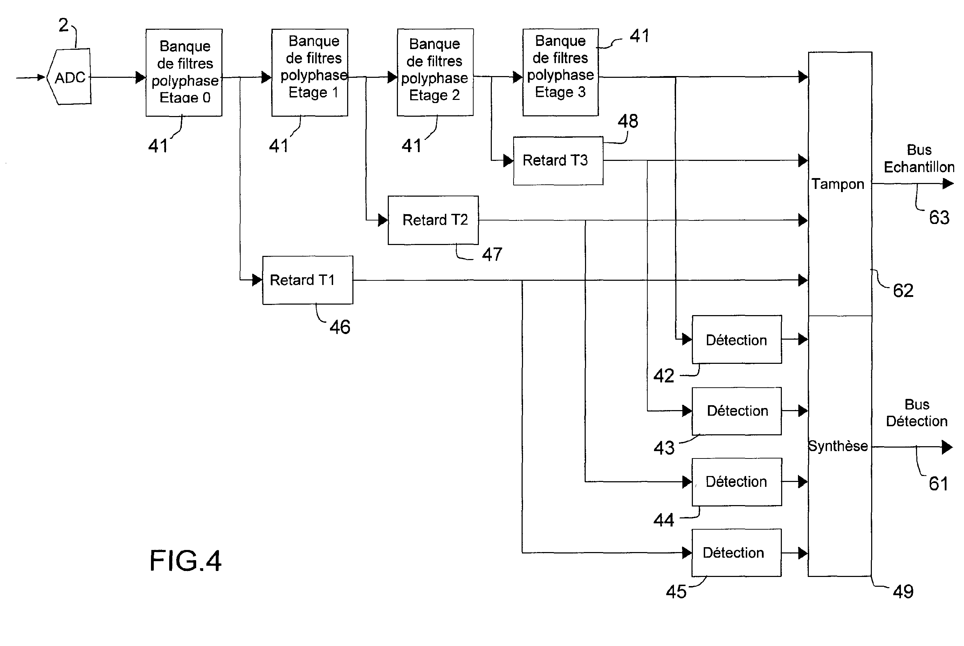

La figure 4 illustre un exemple de réalisation d'un circuit de réception selon l'invention comportant la mise en cascade de filtres 41 selon la figure 3. Le circuit de la figure 4 permet de réaliser le troisième étage du récepteur illustré par la figure 1.

Dans l'exemple de la figure 4, quatre filtres 41 sont reliés en cascade. Le filtre comporte donc quatre étages, chaque filtre polyphasé formant un étage. Le premier étage est un filtre polyphasé basé sur une FFT à 16 points, soit N = 16 dans cet exemple. Celui-ci réalise la transformation réelle complexe, seules les fréquences positives étant conservées. La fréquence de calcul de cet étage est de 160 MHz, la fréquence d'échantillonnage Fs étant telle que :

160 = 2Fs/N, soit Fs = 1280 MHz.

En sortie du premier étage, on obtient N/2 = 8 filtres espacés de :

Fs/N = 1280/16 = 80 MHz échantillonnés à 160 MHz.

Les trois étages suivants sont, par exemple, des filtres polyphases basés sur une FFT 8 points, soit N = 8. Les fréquences de calcul de ces étages étant de 320 MHz. Chaque filtre de sortie du premier étage génère donc N/2 = 4 filtres. Pour les 8 filtres d'entrée issus du premier étage, on obtient donc 4X8 = 32 filtres, espacés de 20 MHz et échantillonnés à 40 MHz. En sortie du troisième étage, on obtient 128 filtres espacés de 5 MHz et échantillonnés à 10 MHz. Enfin, en sortie du quatrième étage, on obtient 512 filtres espacés de 1,25 MHz et échantillonnés à 2,5 MHz.

L'ensemble des quatre étages subdivise donc le canal d'entrée, en sortie du convertisseur 2, ayant une largeur de bande de fréquence B en N canaux ayant une largeur de fréquences B/N en sortie. Dans l'exemple de la figure 4, avec N = 4, une cascade de 4 filtres polyphase, permet ainsi de réaliser simultanément :

- 8 filtres de 80 MHz
- 32 filtres de 20 MHz
- 128 filtres de 5 MHz
- 512 filtres de 1,25 MHz

La réduction de N/2 filtres entraîne une réduction du spectre selon la relation suivante :

$$\text{Réduction de part et d'autre du filtre} = \frac{Fs}{2}\left(\frac{1}{2} - \frac{1}{N}\right)$$

où Fs est la fréquence d'échantillonnage de sortie de l'étage précédent.

Dans l'exemple de la figure 4, la réduction en fonction de l'étage est donnée par le tableau suivant :

| Etage | Fs | N | Réduction (MHz) | Bande utile (MHz) |
|-------|------|----|-----------------|-------------------|
| 1 | 1280 | 16 | | 640 |
| 2 | 160 | 8 | 30 | 580 |
| 3 | 40 | 8 | 7.5 | 565 |
| 4 | 10 | 8 | 1.875 | 561.25 |

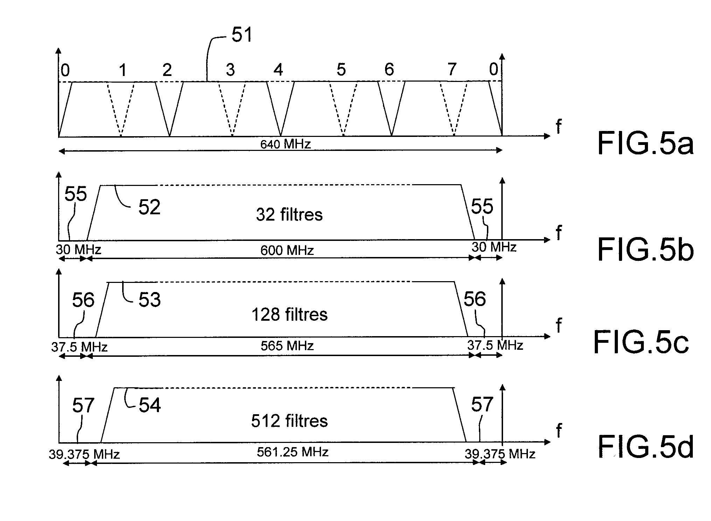

Les figures 5a à 5d illustrent les filtres obtenus, toujours pour l'exemple de la figure 4.

La figure 5a illustre par des courbes 51 les bandes passantes des 8 filtres obtenus en sortie du premier étage. La bande de fréquences utile couverte par ces filtres est de l'ordre de 640 MHz. Pour ce premier étage, il n'y a pas de réduction de spectre.

Les figures 5b, 5c et 5d illustrent respectivement par des courbes 52, 53, 54 l'ensemble des bandes passantes des 32 filtres en sortie du deuxième étage, l'ensemble des bandes passantes des 128 filtres du troisième étage et l'ensemble des bandes passantes des 512 filtres du quatrième étage. La bande utile couverte par ces filtres est de l'ordre de 580 MHz. Une réduction 55 de spectre de 30 MHz apparaît sur le filtre 52 du deuxième étage. Une réduction 56 de spectre de 37,5 MHz apparaît sur le filtre 53 du troisième étage. Une réduction 57 de spectre de 39,375 MHz apparaît sur le filtre 54 du quatrième étage.

En augmentant le nombre d'étages la bande utile converge vers 560 MHz. Cette valeur est compatible d'un filtre analogique anti-repliement qui permet de limiter, par exemple, la bande à 500 MHz avec une fréquence d'échantillonnage de 1280 MHz.

On revient à la figure 4. La sortie du quatrième étage est reliée à l'entrée d'un premier circuit de détection 42. Les sorties des troisième, deuxième et premier étages sont respectivement reliées à l'entrée d'un deuxième 43, troisième 44 et quatrième 45 circuit de détection. Eventuellement, ces trois étages sont reliés aux circuits de détection via des circuits à retard 46, 47, 48. Ces circuits à retard compensent les temps de transit dans les différents étages et permettent ainsi notamment de synchroniser les signaux qui entrent dans les circuits de détection 42, 43, 44, 45. Les sorties des circuits de détection sont reliées par exemple à un circuit de synthèse 49 qui regroupe les informations de détection pour les délivrer sur un bus 61. Le circuit de la figure 4 formant l'étage de traitement 3 de la figure 1, hors convertisseur analogique-numérique, avec au moins les fonctions de filtrage et de détection, les données délivrées sur le bus 61 sont, par exemple, transférées par le bus lui-même vers le quatrième étage 4 du récepteur de la figure 1 ou vers un circuit de caractérisation 7 si nécessaire. Les sorties des étages de filtrage 41 sont par exemple reliés par ailleurs, via les circuits à retards 46, 47, 48 à un circuit tampon 62 destiné notamment à stocker les signaux afin d'être récupérés, via un bus 63, et traités le cas échéant par d'autres circuits.

**Revendications**

1. Dispositif de filtrage d'un signal numérique échantillonné à une fréquence d'échantillonnage donnée Fs, **caractérisé en ce qu'**il comporte au moins :

   - en entrée, un circuit (31) de transposition en fréquences du signal numérique ;
   - un filtre polyphase (30), cadencé à la fréquence d'échantillonnage Fs du signal numérique entrant, recevant en entrée le signal numérique transposé en fréquences et comportant un filtre à FFT (32) ayant un nombre N de points ;

   la sortie dudit dispositif de filtrage conservant un nombre donné de sorties (36) du filtre à FFT (32) de façon à ce que le débit d'informations binaires en sortie dudit dispositif soit égal au débit d'informations binaires en entrée.

2. Dispositif selon la revendication 1, **caractérisé en ce que** N/2 sorties (36) du filtre à FFT sont conservées.

3. Dispositif selon l'une quelconque des revendications précédentes, **caractérisé en ce que** le circuit de transposition en fréquences (31) effectue une transposition sensiblement égale à Fs/2N.

4. Dispositif selon la revendication 3, **caractérisé en ce que** le circuit de transposition en fréquences (31) est un multiplieur complexe multipliant le signal numérique en entrée (38) par le nombre complexe :

$$\exp(2j\pi\frac{Fs}{2N}t)$$

exp () représentant la fonction exponentielle et t représentant le temps.

**5.** Circuit de réception d'un signal comportant un circuit de conversion analogique-numérique (2) du signal reçu, **caractérisé en ce qu'**il comporte un circuit de filtrage (5) du signal reçu numérisé, formé de dispositifs de filtrage selon l'une quelconque des revendications précédentes connectés en cascade, chaque dispositif de filtrage formant un étage de la cascade, les sorties (36) d'un dispositif de filtrage étant connectées à l'entrée (38) du dispositif de filtrage suivant, l'ensemble des filtres de sortie (51, 52, 53, 54) des différents étages formant une banque de filtres, au moins un filtre étant adapté au signal reçu numérisé.

**6.** Circuit de réception selon la revendication 5, **caractérisé en ce qu'**il comporte un circuit de détection formé de circuits de détection élémentaires (42, 43, 44, 45), un circuit de détection élémentaire étant connecté en sortie des filtres de chaque étage (41).

**7.** Circuit de réception selon la revendication 5, **caractérisé en ce que** les sorties des circuits de détection élémentaires (42, 43, 44, 45) sont reliées à un circuit de synthèse (49) pour traiter les signaux filtrés.

**8.** Circuit de réception selon l'une quelconque des revendications 6 ou 7, **caractérisé en ce que** chaque circuit de détection élémentaire (42, 43, 44, 45) est relié à un étage (41) via un circuit à retard (46, 47, 48) compensant le temps de transition du signal dans les étages précédents.

**9.** Circuit de réception selon l'une quelconque des revendications 5 à 8, **caractérisé en ce qu'**il comporte en amont du circuit de conversion analogique-numérique (2) un circuit de transposition en fréquences (1) du signal reçu.

**10.** Circuit de réception selon l'une quelconque des revendications 5 à 9, **caractérisé en ce qu'**il est incorporé dans la chaîne de réception de signaux radar.

FIG.1

EP 1 940 023 A2

FIG.2

FIG.3

FIG.4

EP 1 940 023 A2

FIG.5a

FIG.5b

FIG.5c

FIG.5d

EP 1 940 023 A2